# EUROPEAN PATENT APPLICATION

(11) **EP 3 065 283 A1**
(43) Date of publication of application: **07.09.2016**
(21) Application number: 16158968.4
(22) Date of filing: 07.03.2016
(51) Int. Cl.: H02M 7/00, H05K 7/00, H05K 7/14, H05K 7/20

(54) **INTEGRATED POWER MODULE**

(30) Priority: 06.03.2015 GB 201503806
(71) Applicant: Nissan Motor Manufacturing (UK) Ltd., Cranfield Bedfordshire MK43 0DB (GB)
(72) Inventor: URQUHART, Iain, Bedfordshire, MK43 0DB (GB); GREENOUGH, Jim, Bedfordshire, MK43 0DB (GB)

(57) **Abstract**

An integrated power module for a drive system of a grid-enabled vehicle, the power module comprising: a mounting platform defining a first mounting surface and a second mounting surface, a first group of one or more electronics components mounted to the first mounting surface, and a second group of one or more electronics components mounted to the second mounting surface; and a cover arrangement for covering the electronics components mounted to the first and second mounting surfaces. The mounting platform is provided with a cooling arrangement which, in one embodiment, may be a fluid-based cooling arrangement.

## Description

### Field of the invention

The invention relates to an integrated power module for a drive system of a grid-enabled vehicle.

### Background of the invention

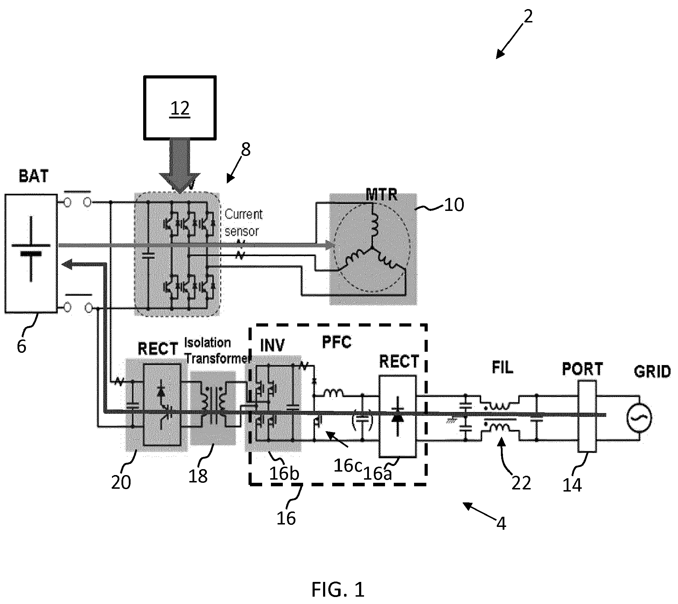

The drive system of a grid-enabled is complex. Consider a typical plug-in electric vehicle (PEV) or grid-enabled vehicle, as is shown schematically by way of example in Figure 1. As can be seen, the PEV shown here includes a drive system 2 and a charging system 4. These systems are separate both functionally and electronically. It will be appreciated that other vehicle sub-systems aren't shown here for brevity.

In overview, the drive system 2 includes a high power battery pack 6, a drive module 8 in the form of a DC/AC inverter (hereinafter 'inverter 8'), and an AC electric machine 10 - typically AC driven motors are used in EV applications. The battery pack 6 supplies DC power to the inverter 8 which switches the supplied power under the control of inverter control means 12 into a suitable 3-phase AC power supply for the electric machine 10.

The charging system 4 includes a grid power input port 14, a PFC (power factor correction) stage 16, a transformer 18 and a rectifier module 20. In a charging mode, the grid input power port 10 receives AC input power from the electrical grid which is then routed through a suitable filter 22 to the PFC stage 16. As is known, the PFC stage 16 includes functionality to control the input power factor from the grid at unity and here includes an AC/DC rectifier 16a a DC/AC inverter 16b, and a PFC module 16c having a boost converter topology, in series. The output of the PFC stage 16 feeds into the transformer 18 which supplies the rectifier module 20. The rectifier module 20 in turn converts the AC power input from the transformer 18 into a suitable voltage supply for the battery pack for the period of the charging cycle. Thus, the inverter 16b, which has an H-bridge topology, the transformer 18 and the rectifier module 20 function as a DC-DC converter, whereby the inverter 16b is controlled by a battery controller (not shown) to generate a required charging voltage which is then switched across the transformer 18 and is then rectified back into DC by the rectifier module 20.

The transformer 18 is an isolation transformer of a kind that will be familiar to the skilled reader, and is included to provide galvanic isolation (i.e. to eliminate direct electrical conduction paths) between the grid supply and any components that are connected to the vehicle chassis, such as the battery pack. This is a safety feature, to ensure that a user is not exposed to grid voltage in the case of a fault.

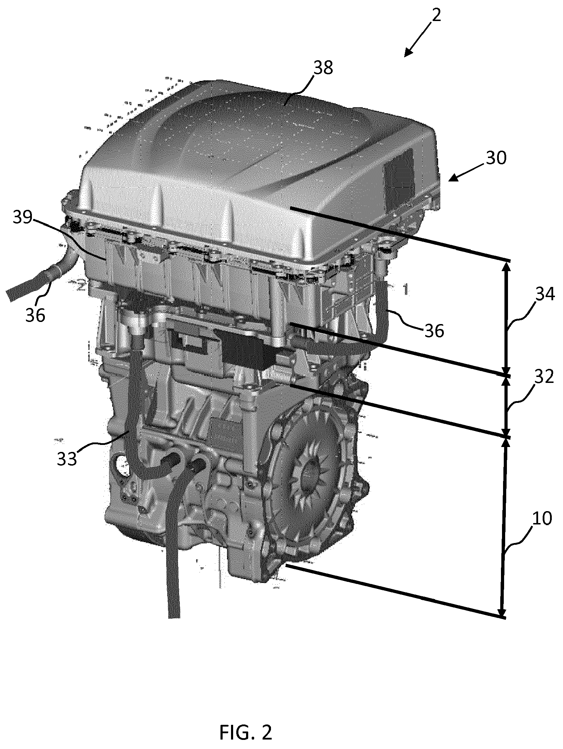

Figure 2 shows, in effect, the drive system 2 of Figure 1 in physical form as would be installed in a vehicle. The electric machine 10 is the lowermost component and the electronics components discussed above are carried on top of the electric machine 10 in the form of an integrated power module 30.

The integrated power module 30 is provided in sections. The first section is the inverter section 32. The inverter section 32 houses the switching electronics for the electric machine 10, i.e. the drive module 8, and includes a cooling circuit 33 for regulating the operating temperature of the components within it. On top of the inverter section 32 is the power distribution section 34. The power distribution section 34 houses numerous electronic components; for example the components of the charger system 4, voltage converter electronics responsible for converting the 400VDC supplied by the battery 6 to 14VDC for the vehicle bus, and the various capacitors in the drive system 2. It also includes a cooling circuit 36 for regulating the components housed within. A tray-shaped cover 38 fits over and attaches to a base section 39 to protect the electronic components housed within the power distribution section 34.

An aim in modern vehicle design is to minimise the size of components so that they take up less space within the vehicle. This design goal generally achieves a related benefit of reducing weight.

It will be appreciated from Figure 2 that the drive system is quite large so, against this background, an objective of the invention is to provide a drive system which is smaller and lighter.

### Summary of the invention

In one aspect, the invention provides an integrated power module for a drive system of a grid-enabled vehicle, the power module comprising: a mounting platform defining a first mounting surface and a second mounting surface, a first group of one or more electronics components mounted to the first mounting surface, and a second group of one or more electronics components mounted to the second mounting surface; and a cover arrangement in two parts for covering the electronics components mounted to the first and second mounting surfaces. The mounting platform also includes a cooling arrangement comprising a fluid flow means and wherein the first group and second group of electronics components together include components for providing power to an electric machine (42) of an associated drive system (40), and components for providing power to an associated energy storage module.

The dual mounting surface arrangement of the mounting platform provides a more space efficient configuration which is a particular benefit for a multi-functional power module that provides facilities, for example, to drive an electric machine, to charge a vehicle battery, to provide DC bus power to the vehicle power distribution system, and so on. Combined with the cooling arrangement, the mounting platform has the facility to accommodate a high number of electrical components, but also is able to dissipate the heat generated by those components during operation, making it particularly suitable for use in relatively high power applications.

In one embodiment, the cooling arrangement includes a fluid flow means, which may be a cooling passage running through the mounting platform. The cooling passage may, therefore, allow fluid to flow through the mounting platform between a fluid inlet and a fluid outlet. In some embodiments, the cooling passage may be a pipe that is installed in the mounting platform. However in one embodiment, the cooling passage is defined by, and so is an integral part of, the mounting platform. In this embodiment, the cooling passage may be cast or otherwise machined into the mounting platform during manufacture.

So that the mounting arrangement is able to dissipate heat that is generated from the various electronic components that are mounted to it, it may be made from a material having a suitable high coefficient of thermal conductivity. For example, it may be a metallic material such as steel or aluminium, or alloys thereof.

In one embodiment, the mounting platform is a mounting plate, which is generally planar. The mounting surfaces may therefore be provided on either side of the plate and, when configured in this way, are generally parallel to one another.

Although the first group of electronic component mounted to the first mounting surface and the second group of electronic components mounted to the second mounting surface may be separate, from a functional perspective, in one embodiment the mounting platform may include at least one through-way, for example in the form of a slot, bore or other aperture, to enable the electronic components on one side of the plate to be connected to electronic components on the other side of the plate.

The cover arrangement fits over the electronic components and therefore provides them with protection from the environmental and chemical attack. In addition, they protect against electric shock.

In one embodiment, the cover arrangement includes first and second cover portions, each cover portion protecting a respective one of the group of electronics components. The cover portions may be mounted directly to the mounting plate which therefore provides that an edge of the mounting plate is exposed to the surround air, which benefits heat dissipation.

In one embodiment, the cover portions have substantially the same top profile as the mounting platform. This has the effect that the overall assembly of the mounting platform and the cover portions appear as a single block having edge surfaces that are flush so as to merge with one other. This is a space efficient configuration that has a uniform shape which is easily arranged in the engine space around other components.

Within the scope of this application it is intended that the aspects, embodiments, examples and alternatives set out in the preceding paragraphs, in the claims and/or in the following description and drawings, and in particular the individual features thereof, may be taken independently or in any combination, unless such features are expressly mentioned as incompatible.

### Brief description of the drawings

For a more detailed understanding of the invention, it will now be described by way of example with reference to the following drawings in which:
Figure 1 is a circuit diagram of a drive system for a grid-enabled vehicle;
Figure 2 is a perspective view of a physical implementation of the drive system in Figure 1;
Figure 3 is a perspective view of a drive system for a grid-enabled vehicle according to an embodiment of the invention, including an integrated power module and an electric machine;
Figure 4 is a circuit diagram of the drive system in Figure 3;
Figure 5 is a perspective view of the integrated power module in isolation from the electric machine;
Figure 6 is an exploded perspective view of the integrated power module in Figure 5;
Figure 7 is a perspective view of a mounting platform of the integrated power module;
Figure 8 is a top view of the mounting platform illustrating the configuration of a cooling circuit; and
Figure 9 is a section view of a part of the mounting platform that illustrates a mounting configuration for an electronics component.

### Detailed description of embodiments of the invention

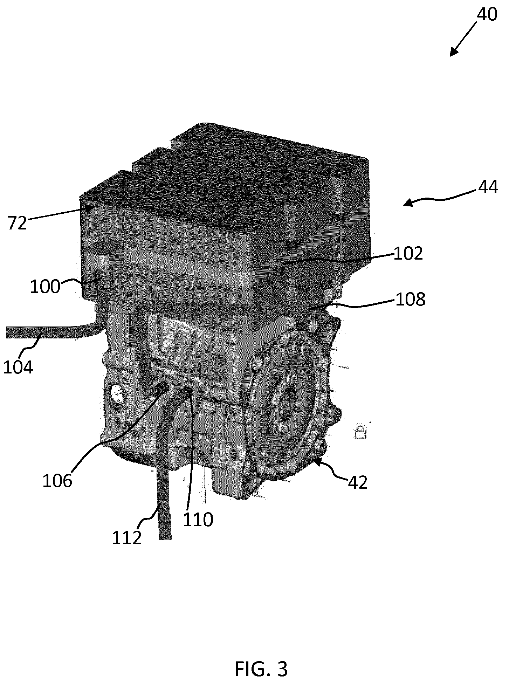

Referring firstly to Figure 3, a drive system 40 for a grid-enabled vehicle includes an electric machine 42 and an integrated power module 44. As will be explained, the integrated power module 44, hereinafter simply 'power module', provides all the electronic functionality for driving the electric machine 42 and further ancillary functions.

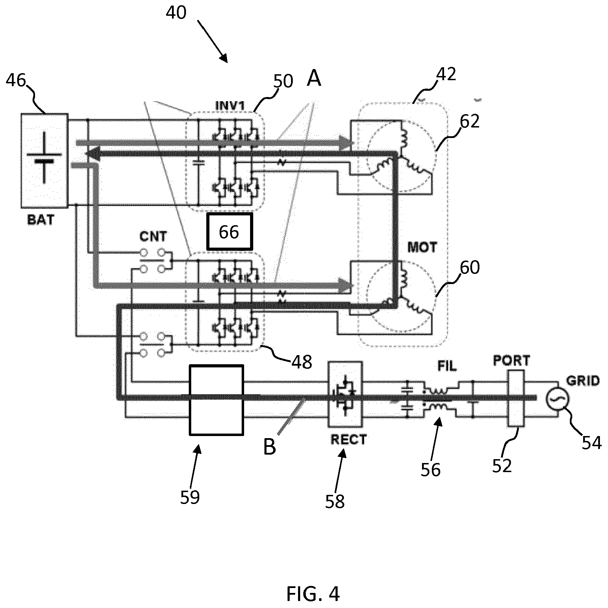

For completeness of this description, Figure 4 illustrates schematically the electrical configuration of the drive system 40 which, as will be appreciated, integrates vehicle propulsion and also the battery charging function. The electrical configuration of the drive system 40 will firstly be described with reference to Figure 4 before moving on to the physical configuration of the drive system 40.

In overview, in addition to the electric machine 42 the drive system 40 comprises a bidirectional DC power source or 'battery' 46, a first power electronics module 48, a second power electronics module 50 and an electric grid input port 52.

The grid input port 52 is connectable to a power supply plug of a suitable grid power source 54 which may be a single-phase AC voltage source or a three-phase AC voltage source. The grid input port 52 provides the appropriate physical form factor for connecting to a plug provided at a charging point, and such an interface is known generally in the art.

The grid input port 52 links to the first power electronics module 48 through a charge input filter 56,a rectifier 58, and a power factor correction (PFC) module 59. The charge input filter 56 comprises choke inductors to filter out line noise and interference from the drive system 40 back into the grid during a charging period. The rectifier 58 comprises suitable electrical switches such as a full-wave bridge arrangement that rectifies the input AC grid power to provide a DC voltage to the first power electronics module 48. Also, as is known, the PFC module 59 functions to remove current harmonics from the DC voltage, thereby correcting the power factor, ideally so that PF=1. The skilled person would understand that various PFC topologies would be appropriate such a boost converter topology which is a well understood power factor correction topology for switched mode power supplies. It is envisaged that the PFC module 59 may be an interleaved boost converter topology which, as is known in the art, comprises two boost converters working in parallel and having a 180° phase delay and provides benefits in terms of DC voltage smoothing.

The electric machine 42 includes a first stator field winding 60 and a second stator field winding 62 that are arranged in the stator so as to be magnetically coupled but galvanically isolated and so, in effect, provide the electric machine 42 with the functionality of an isolation transformer. By virtue of this arrangement the drive system 40 may be run in two modes: a drive mode and a charging mode. The precise structural configuration of the electric machine is not central to the invention and so further description will be omitted for clarity.

In the drive mode, as indicated by the arrows labelled 'A' in Figure 4, power is supplied from the battery 46 to the electric machine 42 through both the first power electronics module 48 and the second power electronics module 50 which energise the first and second field windings 60,62, respectively. Here, therefore, it will be appreciated that both the first and second power electronic modules 48,50 are driven as inverters to convert the DC power supplied from the battery 46 to AC power for the electric machine 42. The first and second field windings 60,62 thus act together, in synchrony, to generate a synchronised rotating electromagnetic field that, in turn, causes the electric machine 42 to acts as a motor.

In the charge mode, as indicated by the arrow labelled 'B' in Figure 4, AC power is supplied by the grid input port 52, is converted to DC by the rectifier 58, in conjunction with the PFC module 59, and then is converted back into AC by the first power electronic module 48 from where it is supplied to the first field winding 60. In this mode, the second field winding 62 is not driven electrically by the second power electronics module 50; instead the magnetic coupling between the first field winding 60 and the second field winding 62 acts in the manner of a transformer and induces an alternating magnetic field in the second field winding 62 which delivers energy to the second power electronic module 50. The second power electronic module 50 is therefore driven as an active rectifier so as to convert the AC power generated by the second field winding 62 to DC power for supply to the battery 46.

It will be appreciated from the above explanation that each of the first and second power electronics modules 48,50 is a three-phase active rectifier-inverter that can be controlled to function either as an inverter, to convert DC power to AC power, or as an active rectifier to convert AC power to DC power. As shown in Figure 4, each of the power electronic modules 48,50 is controlled by a common power controller 66. Expressed another way, the first and second electronic modules 48,50 function together as a dual-active bridge DC-DC converter in which the first and second field windings 60,62 of the electric machine 42 serve as the isolating transformer of the charging circuit.

Each power electronics module 48,50 has the same circuit configuration and includes a three phase bridge set comprising six high speed power switches such as IGBTs, although it should be noted that other switching means such as MOSFETs may be used. Low pass capacitor-based filters are included on the DC side of the power electronics modules 48,50 in order to remove residual AC components on the converted DC voltage line. Such a configuration would be familiar to the skilled person.

Having described the electrical configuration of the drive system 40, the focus will now return to Figure 3, as well as Figures 5 to 8, which show the power module 44 in greater detail.

In broad terms, the power module 44 houses the electronic components to supply power to and to control the electric machine 42, and the components have been described above with reference to Figure 4. However, an objective of the invention is that the power module 44 should be a compact unit which takes up less space within the vehicle and is also lighter, which has a benefit it terms of energy efficiency of the vehicle as a whole. The power module 44 should also i) protect the electronic components housed within it from mechanical and environment shock, ii) isolate the components electrically from surrounding parts of the vehicle, and from unintended contact with users of the vehicle, and iii) provide a temperature regulation function. In addition, further functions may be to provide a suitable/secure means of mounting the assembly to the electric machine 42 and facilitate connection between the first and second power electronics modules 48/50 and the field windings 60/62, and to provide a means of connecting to other vehicle systems - battery, CAN bus, power supply harness from vehicle charging port, for example.

In more detail, the power module 44 comprises a mounting platform 70 and a cover arrangement 72. The mounting platform 70 is arranged to carry electronic components on its surface, and the cover arrangement 72 is arranged to provide a protective cover about the electronics components.

The mounting platform 70 is a solid body that is plate-like in form in this embodiment. In effect, the mounting platform 70 is 'double-sided', in that it defines a first mounting surface 74 and an opposed second mounting surface 76 that are generally parallel to one another. The electronics components are arranged on each of the first and second mounting surfaces 74,76.

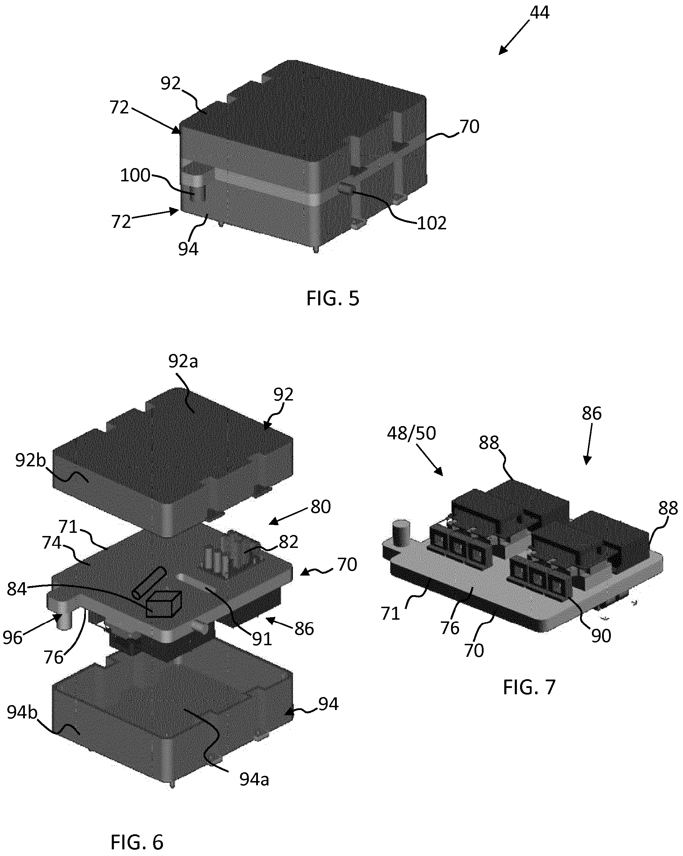

Figure 6 shows the first or 'upper' mounting surface 74, whilst Figure 7 shows the second or 'lower' mounting surface 76 so that the various electronic components can be viewed.

As can be seen the first mounting surface 74 includes a first group 80 of one or more electronics components and, in this embodiment, includes the power factor correction unit 82 (equating to the PFD module 59 in Fig. 4), a DC/DC conversion unit 84 which, as is known, is responsible for stepping down the relatively high voltage from the drive battery 46 to a voltage level that is compatible for the 'low voltage' (e.g. 14VDC) bus of the vehicle. The first group 80 may also include further associated components that are not described here.

The second mounting surface 76 includes a second group 86 of one or more electronics components and, in this embodiment, includes the first and second power electronics module 48, 50, associated capacitors 88 and current sensing assemblies 90. Although the first and second groups of electronics components 80,86 that are carried on the respective mounting surfaces 74,76 of the mounting platform 70 may be functionally separate, it may be desirable in some circumstances to provide for an electrical interconnection between the first and second groups 80,86, such as a voltage rail or a data bus for example. To provide this facility the mounting platform 70 defines a through-way in the form of an elongate slot 91, although different configuration of through-way would also be acceptable.

The cover arrangement 72 comprises two box-like cover portions 92,94. One of the cover portions 92 is mounted to the first mounting surface 74 and the other of the cover portions 94 is mounted to the second mounting surface 76. Each cover portion includes a base 92a,94a and a side wall 92b,94b. The side wall includes recesses 92c,94c which provide a means for the cover portions to be fixed to the mounting platform with suitable mechanical fasteners (not shown). The dimensions of the cover portions 92,94, in plan view, are comparable with the dimension of the mounting platform 70 such that the side walls 92b,94b of the cover portions 92,94 are flush with an outer edge 71 of the mounting platform 70. The cover portions therefore have substantially the same top profile as the mounting platform.

The cover portions 92,94 therefore provide a protective enclosure for the electronics components on the mounting platform 70 that is both electrically insulating and thermally insulating. It is envisaged that the cover portions 92,94 would be made of a polymeric material providing the required protective and insulating characteristics suitable for the environment in which it would be installed. An example of such a material is polyurethane, that could be cast or thermo-formed into the desired shape. An important factor in the selection of the material of the cover portions is that it is compliant with the relevant standards and regulations governing the insulation and protection of the vehicle and driver from high voltage lines.

As well as providing a space efficient double-sided mounting arrangement for the electronics components, the mounting platform 70 also serves as a heat sink so as to provide a temperature regulation function for the electronics components.

To enhance the cooling properties of the mounting platform 70, it is provided with a cooling arrangement 96. In this embodiment, the cooling arrangement 96 incorporates a fluid flow means in the form of a fluid passage 98 that is defined through the otherwise sold body of the mounting platform 70. The fluid passage is therefore an integral part of the mounting platform 70. The fluid passage 98 may be formed in different ways. For example, it may be cast into the mounting platform during manufacture, or may be defined by separate portions of the mounting platform that define matching features such that the complete fluid passage 98 is defined when the separate portions are brought together.

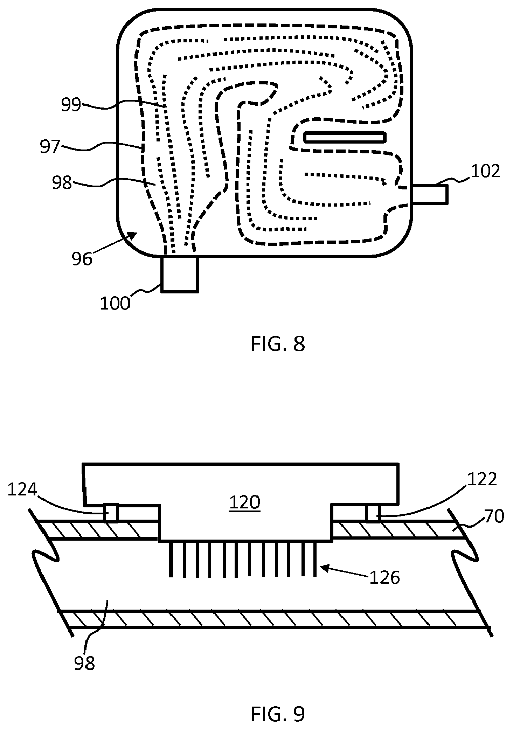

The fluid passage 98 can be seen by the inlet/outlet ports 100,102 in Figures 3, 5, 6 and 7, and can be seen running through the otherwise solid body of the mounting platform 70 in Figure 8. Here, the fluid passage 98 is defined by an outer wall 97 and a series of inner walls or partitions 99 which guide the direction of flow of the fluid between the inlet and outlet ports 100,102 thereby ensuring that the fluid flows evenly through the mounting platform 70 and guards against the generation of hotspots. Fluid is supplied to the inlet port 100 by way of a pipe 104 that is connected to a suitable vehicle cooling system (not shown). The outlet port 102 is connected to an inlet port 106 of a cooling system (not shown) of the electric machine 42 by a second pipe 108. The electric machine 42 also includes an outlet port 110 which is connected to a further pipe 112 which returns coolant fluid back to the vehicle cooling system (not shown).

To ensure that heat is transferred efficiently from the electronics components to the fluid passing through the cooling arrangement 96, the mounting platform 70 is preferably a metallic material with a high thermal conductivity. It is currently envisaged that the mounting platform 70 will be a cast component of aluminium or a suitable alloy thereof, although this should not be considered as limiting. The mounting platform could also be formed of separate portions, e.g. two halves that are brought together to define the complete platform.

The electronics components may be surface-mounted to the respective first or second mounting surface 74,76 by a suitable mounting technique, for example by mechanical fasteners or thermally conductive paste, so they form a good surface-to-surface contact. This will be acceptable in many cases to ensure that sufficient heat transfer takes place from the electronics components into the mounting platform 70 and, thus, to the cooling fluid flowing through the fluid passage 98.

However, some components may generate significantly more heat than others such that a greater heat transfer rate is needed. In this embodiment, therefore, it is envisaged that at least one of the electronics components may be mounted to the first mounting surface 74 or the second mounting surface 76 in such a way that a portion of the electronics component is directly in contact with the cooling fluid in the fluid passage 98. This is illustrated in Figure 9. Here, the electronics component 120 is mounted to the upper mounting surface 74 of the mounting platform 70 by first and second fasteners 122,124. The underside of the electronics component 100 has a 'pin-fin' arrangement 126 that extends into the fluid passage 98. The pin-fin arrangement 126 therefore increases the surface area of the electronics component 120 that is in contact with the coolant fluid and so increases the heat transfer rate. Note that a 'pin fin' arrangement is not essential, and that an alternate means to increase the heat transfer rate into the fluid could also be used. This mounting technique may be particularly applicable to the first and second power electronics modules 48,50 which, by virtue of the switching components (e.g. IGBTs or FETs), that switch high currents at high speed, thereby dissipating a significant amount of heat during operation.

The skilled person will appreciate that various modifications may be made to the above embodiments without departing from the scope of the invention as defined by the claims.

## Claims

1. An integrated power module (44) for a drive system (40) of a grid-enabled vehicle, the power module comprising:
a mounting platform (70) defining a first mounting surface (74) and a second mounting surface (76),
a first group (80) of one or more electronics components mounted to the first mounting surface, and a second group (86) of one or more electronics components mounted to the second mounting surface,
a cover arrangement (72) comprising two parts (92, 94) for covering the electronics components mounted to the first and second mounting surfaces,
wherein the mounting platform is provided with a cooling arrangement (96), the cooling arrangement comprising a fluid flow means; and wherein:
the first group and second group of electronics components together include components for providing power to an electric machine (42) of an associated drive system (40), and components for providing power to an associated energy storage module.

2. The integrated power module of claim 1, wherein the fluid flow means comprises a cooling passage (98) running through the mounting platform.

3. The integrated power module (44) of claim 2, wherein the cooling passage (98) is defined by, and so is an integral part of, the mounting platform (70).

4. The integrated power module (44) of claim 3, wherein the cooling passage (88) is defined by separate portions of the mounting platform.

5. The integrated power module (44) of claims 1 to 4, wherein the mounting platform (70) is a mounting plate.

6. The integrated power module (44) of claim 5, wherein the first and second mounting surfaces (74, 76) are provided on different sides of the mounting plate.

7. The integrated power module (44) of claims 1 to 6, wherein the first mounting surface (74) is generally parallel to the second mounting surface (76).

8. The integrated power module (44) of claims 1 to 7, wherein the mounting platform (70) includes at least one through-way (91) to enable electronics components mounted on the first mounting surface (74) to be connected to electronic components mounted to the second mounting surface (76).

9. The integrated power module (44) of claims 1 to 8, wherein the cover arrangement (72) comprises a first cover portion (92) covering the first group of one or more electronics components and a second cover portion (94) covering the a second group of one or more electronics components.

10. The integrated power module (44) of claim 9, wherein the first cover portion and the second cover portion (92,94) are mounted to the mounting platform (70).

11. The integrated power module of claim 10, wherein the first cover portion (92) is mounted to the first mounting surface (74).

12. The integrated power module of claims 10 or 11, wherein the second cover portion (94) is mounted to the second mounting surface (76).

13. The integrated power module (44) of any of claims 9 to 11, wherein the first and/or second cover portions (92, 94) are substantially the same in top profile as the mounting platform (70).

14. The integrated power module of any preceding claim, wherein the first group and second group of electronics components together include components for providing power to an electrical machine of an associated drive system, and components for providing power to an associated energy storage module.

15. The integrated power module of any preceding claim, further including components for providing power to an associated power distribution system of an associated vehicle.

16. A drive system (40) for a grid-enabled vehicle including an electric machine (42) and an integrated power module (44) as claimed in any of claims 1 to 15 mounted thereon.
